# EUROPEAN PATENT APPLICATION

(11) **EP 4 786 994 A1**
(43) Date of publication of application: **05.08.2026**
(21) Application number: 25846083.1
(22) Date of filing: 18.06.2025
(51) Int. Cl.: G01R 31/385, G01R 1/067, G01R 1/20

(54) **BATTERY CELL INSPECTION APPARATUS**

(30) Priority: 12.12.2024 KR 20240184412
(71) Applicant: LG ENERGY SOLUTION, LTD., Seoul 07335 (KR)
(72) Inventor: SON, Sehui, Daejeon 34122 (KR)
(74) Representative: Goddar, Heinz J.
(86) International application number: PCT/KR2025/008371
(87) International publication number: WO 2026/127241

(57) **Abstract**

A battery cell inspection device includes a frame, an assembly mounting member which is movably mounted on the frame and on which a cell tray assembly is mounted, an ascent/descent driver mounted on the frame and moving up/down the assembly mounting member, an inspection jig disposed above the assembly mounting member in the frame and contacting a battery cell to measure a voltage of the battery cell, and a stopping member disposed above the assembly mounting member and including at least two stopping surfaces formed at different heights. An ascent height of the assembly mounting member is adjusted through selective contact between a part of the assembly mounting member and the stopping surfaces.

## Description

### [TECHNICAL FIELD]

The present disclosure relates to a battery cell inspection device, and more specifically, to a battery cell inspection device that measures the voltage of a battery cell to inspect electrical performance.

### [BACKGROUND ART]

Unlike primary batteries that cannot be recharged, secondary batteries refer to batteries that can be recharged and discharged and are applied to various apparatus such as electric vehicles (EVs) and hybrid electric vehicles (HEVs) driven by electrical power sources as well as portable devices.

The types of secondary batteries that are currently widely used include lithium ion batteries, lithium polymer batteries, nickel cadmium batteries, nickel hydrogen batteries, nickel zinc batteries, etc. The operating voltage of such a unit secondary battery cell (unit battery cell) is approximately 2.5 V to 4.6 V. Therefore, if a higher output voltage is required, multiple battery cells can be connected in series to constitute a battery pack. In addition, multiple battery cells may be connected in parallel to constitute a battery pack depending on the charge and discharge capacity required for the battery pack. The number of battery cells included in a battery pack may be varied depending on the required output voltage or charge/discharge capacity.

Battery cells are inspected for electrical performance and defects after the manufacturing process is completed. The electrical performance inspection process may be performed by bringing voltage measurement pins of a voltage inspection jig into contact with leads of different electrodes constituting a battery cell, applying current to the voltage measurement pins, and measuring the voltage.

Generally, the battery cell inspection process may include a step of positioning a cell tray assembly with battery cell mounted on a tray at an inspection position, a step of moving down the voltage inspection jig equipped with the voltage measurement pins or moving up the cell tray assembly to contact the voltage measurement pins and the battery cell, and a step of applying current to the voltage measurement pins to measure the voltage.

Since the battery cell can be manufactured at various heights, it is important to adjust the descent height of the voltage inspection jig or the ascent height of the cell tray assembly in order to ensure good contact between the voltage measurement pins and the battery cell. If the height adjustment process can be performed smoothly, a time required to inspect the battery cell can be reduced and the inspection process can be performed smoothly.

### [DETAILED DESCRIPTION OF INVENTION]

### [TECHNICAL PROBLEMS]

The present disclosure has been made to solve the problems of the prior art as described above, and provides a battery cell inspection device capable of smoothly adjusting the height of a cell tray assembly moving up and down.

### [TECHNICAL SOLUTION]

A battery cell inspection device according to a preferred embodiment of the present disclosure provides a frame, an assembly mounting member which is movably mounted on the frame and on which a cell tray assembly is mounted, an ascent/descent driver mounted on the frame and moving the assembly mounting member vertically, an inspection jig disposed above the assembly mounting member in the frame and contacting a battery cell to measure a voltage of the battery cell, and a stopping member disposed above the assembly mounting member and including at least two stopping surfaces formed at different heights. An ascent height of the assembly mounting member is adjusted through selective contact between a part of the assembly mounting member and one of the at least two stopping surfaces.

The inspection jig may include voltage measurement pins coming into contact with an electrode of the battery cell to measure a voltage of the battery cell.

The inspection may be fixed on the frame.

The assembly mounting member may include an assembly support which is movably provided on the frame and moved vertically by operation of the ascent/descent driver and on which the cell tray assembly is mounted, and an ascent limiting rod vertically mounted on the assembly support and having an upper end hitting one of the at least two stopping surfaces of the stopping member when moving upward such that further ascent is limited.

The frame may include a vertical frame as a guide member for guiding ascent/descent of the assembly support.

The stopping member may include a rail horizontally mounted on an upper portion of the frame, and a stopper slidably mounted on the rail and having the at least two stopping surfaces formed at a lower portion of the stopper.

The stopping member may include a pair of rails horizontally mounted on the upper portion of the frame on left and right sides of the frame, a pair of stoppers slidably mounted on each of the rails and having the at least two stopping surfaces formed at lower portions of the stoppers, and a connecting member connecting the pair of stoppers to each other.

The battery cell inspection device may further include a stopping driver mounted on the frame to move the stopper forward and backward.

The ascent/descent driver and the stopping driver may be pneumatic cylinders.

The battery cell inspection device may further include a stopping sensor mounted on the frame to detect sliding positions of the stopper.

The battery cell inspection device may further include a controller configured to control the stopping driving means depending on a height of the cell tray assembly.

Information on the height of the cell tray assembly may be manually input by an operator through an input unit or automatically input through a detection sensor mounted on the frame to detect the height of the cell tray assembly.

### [EFFECT OF INVENTION]

According to the battery cell inspection device of the present disclosure, the ascent/descent height of the cell tray assembly can be adjusted without replacing a stopping member, thereby reducing the time required for the performance inspection of a battery cell. In particular, the ascent/descent height of the battery cell is automatically adjusted by moving the stopping member backward and forward using a stopping driving means, thereby significantly reducing inspection operation time.

### [BRIEF DESCRIPTION OF THE DRAWING]

FIG. 1 is a front view of a battery cell inspection device according to an embodiment of the present disclosure.
FIG. 2 is a side view of the battery cell inspection device according to an embodiment of the present disclosure.
FIG. 3 is a plan view of the battery cell inspection device according to an embodiment of the present disclosure.
FIG. 4 is a front view of a voltage measurement part.
FIG. 5 is a side view of the voltage measurement part.
FIG. 6 is a diagram showing a connection relationship of a measurement frame, an inspection jig, an ascent/descent driving means, a stopping member, and a stopping driving means.
FIG. 7 is a diagram showing a state in which a cell tray assembly is mounted on an assembly mounting member.
FIG. 8 is a diagram showing a state in which the stopping member and the stopping driving means are connected to each other.
FIG. 9 is a diagram showing a state in which two stopping members are mounted facing each other.
FIG. 10 is a diagram showing a state in which a stopper is installed on a rail.
FIG. 11 is a side view of the stopper.
FIG. 12 illustrating changes in an allowable ascent/descent height of the ascent/descent limiting load depending on the position of the stopper.

### [BEST MODE FOR CARRYING OUT THE INVENTION]

Hereinafter, a battery cell inspection device according to a preferred embodiment of the present disclosure will be described in detail with reference to the attached drawings.

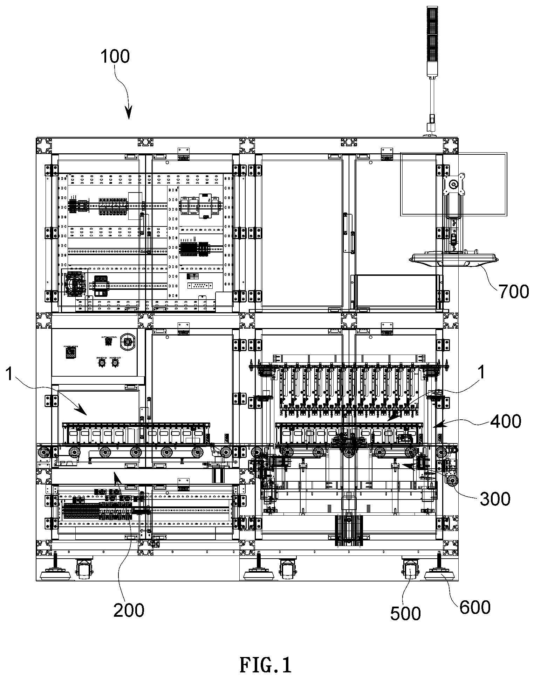

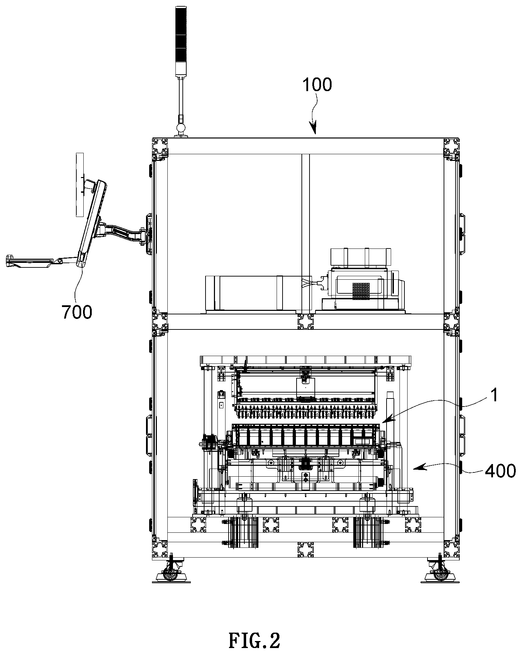

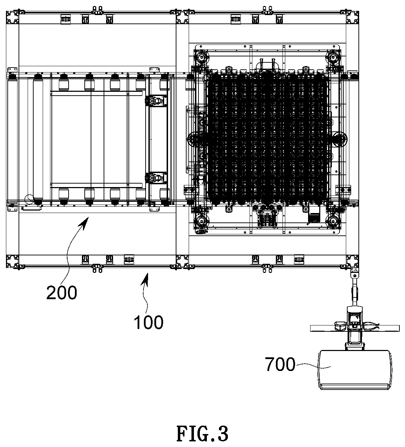

FIG. 1 is a front view of a battery cell inspection device according to an embodiment of the present disclosure, FIG. 2 is a side view of the battery cell inspection device according to an embodiment of the present disclosure, and FIG. 3 is a plan view of the battery cell inspection device according to an embodiment of the present disclosure.

As described above, when the manufacturing process of a battery cell is completed, a battery cell inspection process is performed to inspect the electrical performance and defects of the battery cell.

When the battery cell is applied to an automobile, a plurality of battery cells is configured in the form of a module or a pack and mounted in the automobile, and the battery cells continuously perform charging/discharging in the driving environment of the automobile. If charging/discharging is continuously performed in a state in which the internal characteristics and internal resistances of the battery cells are different, a voltage difference may occur between the battery cells. If the voltage difference between the battery cells accumulates, the battery cells may be overcharged or overdischarged, which may cause fatal damage to the large-capacity battery module or pack.

Even if individual battery cells are good products, there is bound to be a slight voltage deviation. Therefore, in order to prevent performance degradation of a battery module or pack as much as possible, it is necessary to inspect the voltages of individual battery cells and construct a module or pack using battery cells having similar voltages.

The battery cell inspection device according to an embodiment of the present disclosure is for inspecting the voltages of battery cells, and may include a main frame 100, an assembly entry part 200, an assembly positioning part 300, a voltage measurement part 400, and a controller (not shown).

The main frame 100 forms the frame of the battery cell inspection device according to the present disclosure and may be manufactured by assembling square metal bars. A caster 500 for movement and a floor stopper 600 for fixing the inspection device to the floor may be provided on the bottom surface of the main frame 100.

The main frame 100 may be divided into multiple zones according to the assembly form of the metal bars. Different devices may be separately disposed in each zone. For example, the main frame 100 may be divided into two, upper and lower sections, as shown in FIGS. 1 to 3.

In the upper section, a power meter used to measure the voltage of a battery cell along with a voltage measurement pin which will be described later, an air flow meter for controlling the amount of air supplied to cylinders which will be described later, a controller, a monitor 700, etc. may be disposed.

In the lower section, an assembly entry part 200 that guides entry of a cell tray assembly 1 from the outside, an assembly positioning part 300 that positions the cell tray assembly 1 at an inspection position, and a voltage measurement part 400 that measures the voltage of the battery by applying current to the battery cell may be disposed. Here, the cell tray assembly 1 refers to a configuration in which a plurality of battery cells is mounted on a tray.

The assembly entry part 200 and the assembly positioning part 300 may include a plurality of rollers rotatably provided at intervals on both sides of an assembly entry path, a connecting member such as a chain connecting the rollers, and a driving motor that rotates the rollers.

Detection sensors that detect movement of an assembly may be provided on one or both sides of the assembly entry part 200 and the assembly positioning part 300. Detection sensors provided close to the assembly entry part 200 can detect whether the cell tray assembly 1 is correctly entering, and detection sensors provided close to the assembly positioning part 300 can detect whether the cell tray assembly 1 is correctly positioned at the inspection position.

Further, a detection sensor that measures the overall height of the cell tray assembly 1 may be provided at a location close to the assembly entry part 200 or the assembly positioning part 300. A height measurement value of the cell tray assembly 1 detected by the detection sensor may be transmitted to the controller in real time. In this way, if the detection sensor for measuring the height of the cell tray assembly 1 is provided, the height of the cell tray assembly 1 can be automatically calculated in real time by the controller. The height of the cell tray assembly 1 is not only automatically detected by the detection sensor, but may also be provided to the controller in such a manner that, whenever the height of the cell tray assembly 1 changes, an operator manually inputs information on the change to a monitor 700.

According to the battery cell inspection device of the present disclosure, an ascent/descent height of the cell tray assembly 1 may be determined depending on the height of the cell tray assembly 1. This will be described in detail later.

All sensors constituting the battery cell inspection device according to the present disclosure are connected to the controller, and the operation of actuators, i.e., cylinders, which will be described later may be automatically controlled according to control of the controller.

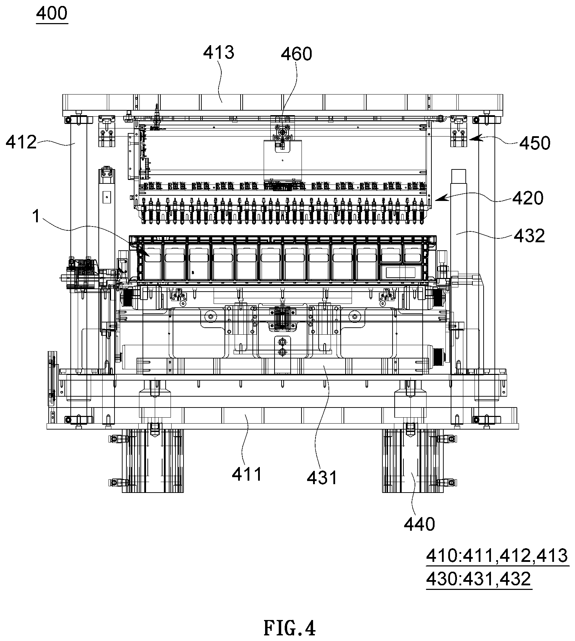

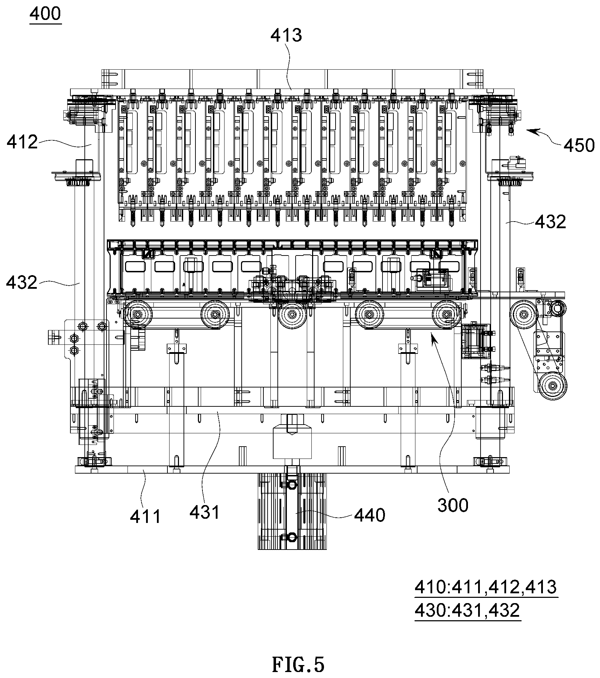

FIG. 4 is a front view of the voltage measurement part, and FIG. 5 is a side view of the voltage measurement part.

The voltage measurement part 400 raises the cell tray assembly 1 located in the assembly positioning part 300, applies current to the battery cells, and measures the voltages of the battery cells, and may include a measurement frame 410, an inspection jig 420, an assembly mounting member 430, an ascent/descent driving means 440, a stopping member 450, and a stopping driving means 460.

The measurement frame 410 is mounted in the area where the assembly positioning part 300 is located in the lower section of the main frame 100, and the assembly positioning part 300 is located inside the measurement frame 410. The measuring frame 410 may include a lower frame 411 mounted on the main frame 100, four vertical frames 412 vertically installed at the four corners of the lower frame 411, and an upper frame 413 connecting the upper ends of the vertical frames 412.

The inspection jig 420 is fixed to the upper frame 413 and is positioned above the assembly positioning part 300 and the assembly mounting member 430. The inspection jig 420 is provided with a plurality of voltage measurement pins 421 that comes into contact with the electrodes of the battery cells to apply current to the battery cells and measure the voltages of the battery cells, which will be described later.

The assembly mounting member 430 is mounted on the measurement frame 410 so as to be able to move up/down, and the cell tray assembly 1 is mounted thereon. When the cell tray assembly 1 enters the assembly positioning part 300 from the assembly entry part 200, an assembly support 431 that constitutes the assembly mounting member 430, which will be described later, is positioned at a lower position than the upper portion of the assembly positioning part 300, and when the cell tray assembly 1 is positioned at the assembly positioning part 300, the assembly mounting member 430 rises along with the cell tray assembly 1 positioned at the assembly positioning part 300 while supporting the cell tray assembly 1.

The ascent/descent driving means 440 is mounted on the measurement frame 410 to move up/down the assembly mounting member 430, and a pneumatic cylinder is used as the ascent/descent driving means 440. However, the present disclosure is not limited thereto and various known driving means including a hydraulic cylinder may be used.

The stopping member 450 is disposed above the assembly mounting member 430 on the upper side of the measurement frame 410 to limit the ascent/descent height of the cell tray assembly 1, and may automatically change the allowable lifting height of the cell tray assembly 1 according to the specifications (particularly, height) of the battery cells. That is, if the type of battery cell changes and thus the height of the cell tray assembly 1 increases, the allowable ascent/descent height of the cell tray assembly 1 may be automatically lowered, and conversely, if the height of the cell tray assembly 1 decreases, the allowable lifting height of the cell tray assembly 1 may be automatically increased.

The stopping driving means 460 is connected to the stopping member 450 and operates the stopping member 450.

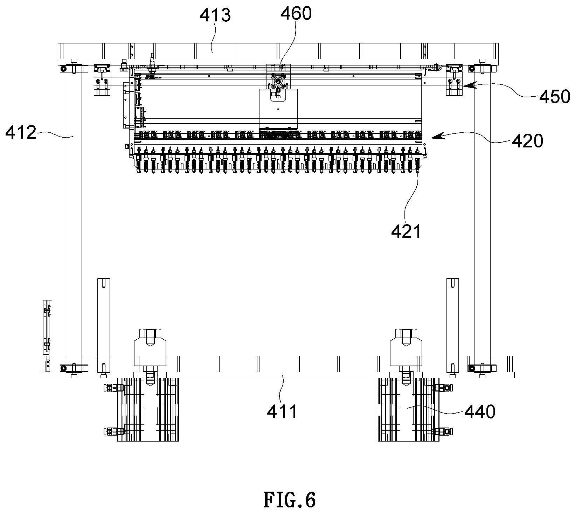

FIG. 6 is a diagram showing a connection relationship of the measurement frame, the inspection jig, the ascent/descent driving means, the stopping member, and the stopping driving means.

As described above, the measurement frame 410 may include the lower frame 411, the vertical frame 412, and the upper frame 413. The vertical frame 412 is provided in the form of a cylinder or a circular pipe and may guide ascent/descent of the assembly mounting member 430.

The inspection jig 420 may be mounted on the upper frame 413, and the plurality of voltage measurement pins 421 for measuring a voltage may be provided on the lower portion of the inspection jig 420. The voltage measurement pins 421 may be connected to the power meter described above. The stopping member 450 and the stopping driving means 460 may be mounted on the outer side of the inspection jig 420 on the upper frame 413.

The ascent/descent driving means 440 may be mounted on the lower frame 411. The ascent/descent driving means 440 may be a pneumatic cylinder, and two ascent/descent driving means may be spaced apart from each other on the lower frame 411. The ascent/descent driving means 440 may be connected to the air flow meter described above. The main frame 100 may be equipped with a compressed air supply for supplying compressed air to the ascent/descent driving means 440. The compressed air supply may be an air compressor, and an air valve for controlling discharge of the compressed air may be connected to a discharge side of the air compressor. The ascent/descent driving means 440 is installed such that a cylinder rod faces upward, and the operation of the cylinder rod may be performed vertically.

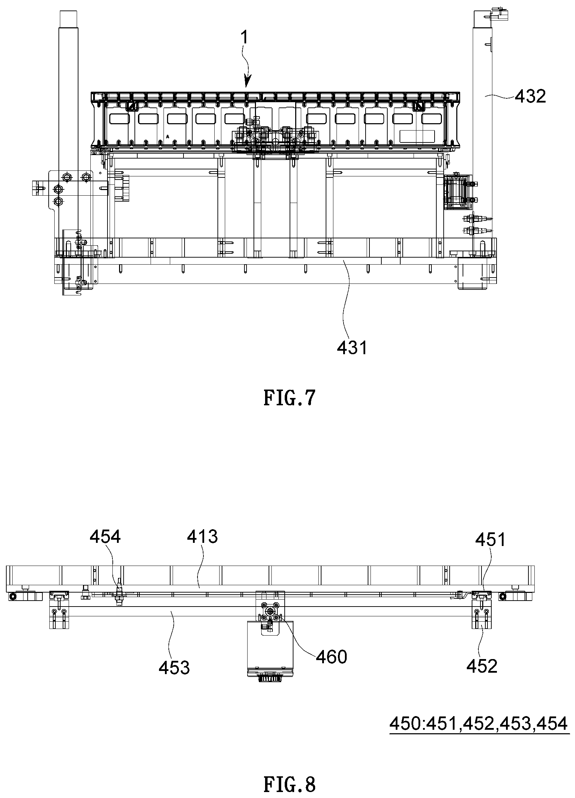

FIG. 7 is a diagram showing a state in which the cell tray assembly is mounted on the assembly mounting member.

The assembly mounting member 430 may include an assembly support 431 and an ascent limiting rod 432.

The assembly support 431 supports the cell tray assembly 1 located at the assembly positioning part 300 with the cell tray assembly 1 placed on the upper surface thereof, and is connected to the end of the cylinder rod of the ascent/descent driving means 440 and thus can be moved up/down by the operation of the ascent/descent driving means 440. The edge of the assembly support 431 is slidably fitted into the vertical frames 412 constituting the measurement frame 410, and thus the assembly support 431 can move up/down while being guided in a horizontal state when the ascent/descent driving means 440 is operated. To this end, frame penetration holes through which the vertical frames 412 slidably penetrate may be formed at the edge of the assembly support 431.

The ascent limiting rod 432 is vertically mounted on each of the four edges of the assembly support 431 at the same height, and when the assembly support 431 moves upward, the upper end of the ascent limiting rod 432 hits the stopping member 450 to limit further ascent of the assembly support 431. That is, when the upper end of the ascent limiting rod 432 comes into contact with a lower surface of a stopper 452 constituting the stopping member 450, which will be described later, further ascent of the ascent limiting rod 432 is limited, and thus further ascent of the assembly support 431 and the cell tray assembly 1 can also be limited.

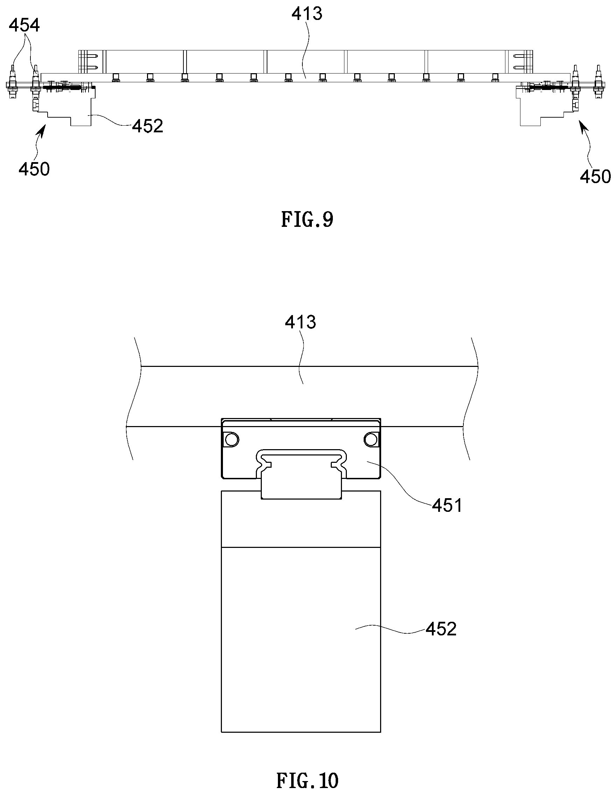

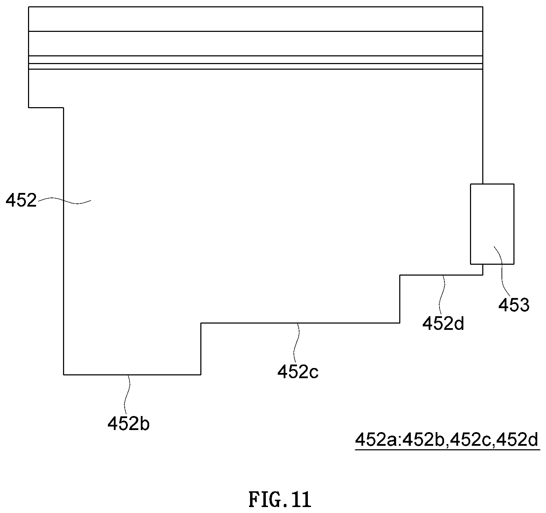

FIG. 8 is a diagram showing a state in which the stopping member and the stopping driving means are connected to each other, FIG. 9 is a diagram showing a state in which two stopping members are mounted facing each other, FIG. 10 shows a state in which the stopper is mounted on a rail, and FIG. 11 is a side view of the stopper.

The two stopping members 450 may be provided facing each other and respectively disposed on the front and rear sides of the upper frame 413 constituting the measurement frame 410.

Each stopping member 450 may include two rails 451, two stoppers 452, a connecting member 453, and a stopping sensor 454.

The two rails 451 are mounted lengthwise in the front and rear directions on the left and right sides of the upper frame 413, respectively and provided horizontally to guide forward and backward sliding of the stoppers 452.

The upper portion of the stopper 452 is slidably inserted and mounted in a groove of the rail 451, and a plurality of stopping surfaces 452a is connected and formed on the lower side of the stopper 452. The stopping surfaces 452a may be formed at different heights. As shown in FIG. 11, the stopping surfaces 452a may include first, second, and third stopping surfaces 452b, 452c, and 452d which may be formed in a stepwise manner, and the position may become higher as it goes from the first stopping surface 452b to the third stopping surface 452d.

The connecting member 453 is formed in a straight square bar shape and connects the two stoppers 452 disposed on the left and right sides of the upper frame 413 to each other, thereby allowing the two stoppers 452 to move forward and backward simultaneously. The connecting member 453 may be connected to the right side of the stopper 452 in the drawing as shown in FIG. 11, and may be detachably fastened to the stopper 452 using a bolt fastening method.

A plurality of stopping sensor 454 may be installed on the upper frame 413 to detect the position of the connecting member 453 and then transmit detection data to the controller. Upon reception of the detection data from the stopping sensors 454, the controller determines the position of the stopper 452 based on the detection data and controls the operation of the stopping driving means 460, thereby automatically controlling the position of the stopper 452.

Meanwhile, the stopping driving means 460 may be a pneumatic cylinder and may be mounted on the upper frame 413 in such a manner that the piston rod moves forward and backward horizontally. The end of the piston rod may be connected to the center of the connecting member 453. Therefore, when the stopping driving means 460 operates, the two stoppers 452 can move forward and backward at the same time. The stopping driving means 460 is not limited to a pneumatic cylinder, and various known driving means including a hydraulic cylinder may be used as the stopping driving means 460.

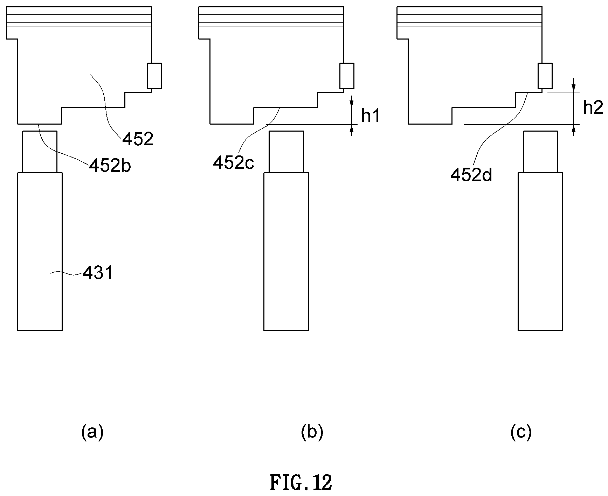

FIG. 12 is a schematic diagram illustrating change in an allowable ascent/descent height of the ascent/descent limiting load depending on the position of the stopper.

As described above, when the height of the cell tray assembly 1 changes, the stopping surface 452a that contacts the ascent limiting load 432 can be changed by sliding the stopper 452 to change the ascent height of the ascent limiting load 432.

As described above, the stopping surface 452a formed on the lower surface of the stopper 452 may include the first stopping surface 452b, the second stopping surface 452c, and the third stopping surface 452d that are stepped such that their heights are different from each other. The position of the surface becomes higher as it goes from the first stopping surface 452b to the third stopping surface 452d. The number and height of the stopping surfaces 452a may be changed in various ways.

The assembly support 431 and the ascent limiting rod 432 move up/down only in the vertical direction in place by the operation of the ascent/descent driving means 440, and as the stopper 452 having the plurality of stopping surfaces 452a, 452b, and 452c having different heights moves forward and backward, the position of the stopping surface 452a that comes into contact with the upper end of the ascent limiting rod 432 is changed, thereby allowing the ascent/descent height of the ascent limiting rod 432 to be adjusted. That is, when the stopper 452 in the state shown in (a) of FIG. 12 moves and is positioned at position (b) of FIG. 12, the ascent limiting rod 432 can further move up by h1, and when the stopper 452 is positioned at position (c), the ascent limiting rod 432 can further move up by h2 (h1 < h2).

When the ascent/descent height of the ascent limiting load 432 is changed, the ascent/descent height of the assembly support 431 and the cell tray assembly 1 can also be changed.

Meanwhile, in the process of positioning the cell tray assembly 1 in the assembly positioning part 300, the height thereof is automatically detected by a detection sensor and a detection signal is transmitted to the controller, and the controller may determine the height change of the cell tray assembly 1 based on the data transmitted from the detection sensor. Information on the height change of the cell tray assembly 1 may also be transmitted to the controller in such a manner that the operator manually inputs the information through the monitor 700.

As described above, the battery cell inspection device according to a preferred embodiment of the present disclosure has been described in detail with reference to the attached drawings, but the present disclosure is not limited to the above-described embodiment, and can be implemented in various ways within the scope of the claims.

### [DESCRIPTION OF REFERENCE NUMERALS]

1: Cell tray assembly 100: Main frame
200: Assembly entry part 300: Assembly positioning part
400: Voltage measurement part 410: Measurement frame
411: Lower frame 412: Vertical frame
413: Upper frame 420: Inspection jig
421: Voltage measurement pin 430: Assembly mounting member
431: Assembly support 432: Ascent limiting load
440: Ascent/descent driving means 450: Stopping member
451: Rail 452: Stopper
453: Connecting member 454: Stopping sensor
500: Caster 600: Fixing stopper
700: Monitor

## Claims

1. A battery cell inspection device comprising:
a frame;
an assembly mounting member which is movably mounted on the frame and on which a cell tray assembly is mounted;
an ascent/descent driver mounted on the frame and moving the assembly mounting member vertically;
an inspection jig disposed above the assembly mounting member in the frame and contacting a battery cell to measure a voltage of the battery cell; and
a stopping member disposed above the assembly mounting member and including at least two stopping surfaces formed at different heights,
wherein an ascent height of the assembly mounting member is adjusted through selective contact between a part of the assembly mounting member and one of the at least two stopping surfaces.

2. The battery cell inspection device of claim 1, wherein the inspection jig includes voltage measurement pins coming into contact with an electrode of the battery cell to measure a voltage of the battery cell.

3. The battery cell inspection device of claim 2, wherein the inspection jig is fixed on the frame.

4. The battery cell inspection device of claim 1, wherein the assembly mounting member comprises:
an assembly support which is movably provided on the frame and moved vertically by operation of the ascent/descent driver and on which the cell tray assembly is mounted; and
an ascent limiting rod vertically mounted on the assembly support and having an upper end hitting one of the at least two stopping surfaces of the stopping member when moving upward such that further ascent is limited.

5. The battery cell inspection device of claim 5, wherein the frame comprises a vertical frame as a guide member for guiding ascent/descent of the assembly support.

6. The battery cell inspection device of claim 4, wherein the stopping member comprises:
a rail horizontally mounted on an upper portion of the frame; and
a stopper slidably mounted on the rail and having the at least two stopping surfaces formed at a lower portion of the stopper.

7. The battery cell inspection device of claim 4, wherein the stopping member comprises:
a pair of rails horizontally mounted on the upper portion of the frame on left and right sides of the frame;
a pair of stoppers slidably mounted on each of the rails and having the at least two stopping surfaces formed at lower portions of the stoppers; and
a connecting member connecting the pair of stoppers to each other.

8. The battery cell inspection device of claim 6 or 7, further comprising a stopping driver mounted on the frame to move the stopper forward and backward.

9. The battery cell inspection device of claim 8, wherein the ascent/descent driver and the stopping driver are pneumatic cylinders.

10. The battery cell inspection device of claim 8, further comprising a stopping sensor mounted on the frame to detect sliding positions of the stopper.

11. The battery cell inspection device of claim 8, further comprising a controller configured to control the stopping driver depending on a height of the cell tray assembly.

12. The battery cell inspection device of claim 11, wherein information on the height of the cell tray assembly is manually input by an operator through an input unit or automatically input through a detection sensor mounted on the frame to detect the height of the cell tray assembly.
